# EUROPEAN PATENT SPECIFICATION

(11) **EP 1 962 564 B1**
(45) Date of publication and mention of the grant of the patent: **07.08.2013**
(21) Application number: 06833615.5
(22) Date of filing: 29.11.2006
(51) Int. Cl.: H05B 33/12, H01L 51/50

(54) **WHITE ORGANIC ELECTROLUMINESCENT DEVICE**
WEISSES ORGANISCHES ELEKTROLUMINESZENZBAUELEMENT
COMPOSANT ÉLECTROLUMINESCENT ORGANIQUE BLANC

(30) Priority: 30.11.2005 JP 2005346403
(43) Date of publication of application: 27.08.2008
(60) Divisional application: 11193862.7
(73) Proprietor: Sumitomo Chemical Company, Limited, Tokyo 104-8260 (JP)
(72) Inventor: UETANI, Yasunori, Tsukuba-shi, Ibaraki 3050045 (JP)
(74) Representative: Benson, John Everett
(86) International application number: PCT/JP2006/323811
(87) International publication number: WO 2007/063897

(56) References cited:
- EP-A- 1 585 175
- EP-A- 1 705 728
- WO-A-2004/100282
- WO-A-2005/059951
- JP-A- 2001 060 493
- JP-A- 2004 346 312
- JP-A- 2005 143 300
- JP-A- 2005 310 742
- JP-A- 2005 310 742
- JP-A- 2005 322 633
- JP-A- 2006 016 577
- JP-A- 2006 245 003
- JP-A- 2006 269 253
- US-A1- 2002 106 529
- US-A1- 2004 097 101
- US-A1- 2005 186 106
- DOMERCQ B ET AL: "Photo-crosslinkable polymers as hole transport materials for organic light-emitting diodes" PROCEEDINGS OF THE SPIE, SPIE, BELLINGHAM, VA, US, vol. 4642, 1 January 2000 (2000-01-01), pages 88-96, XP002297916 ISSN: 0277-786X
- 'Organic Electroluminescence Materials and Displays', 01 January 2001, CMC, JAPAN, ISBN 97848823128410 deel KIDO JUNJI: 'Organic Electroluminescence Materials and Displays', pages 241 - 257, XP055017049

## Description

### Technical Field

The present invention relates to a white organic electroluminescent device.

### Background Art

Organic electroluminescent device (hereinafter sometimes referred to as "organic EL device") is a general term for devices which use organic compounds as light-emitting materials or charge-transporting materials in light-emitting layers. In producing organic EL devices, a method of wet coating a solution of polymer material is superior in productivity to a method of vapor depositing a low molecular material. Among the organic EL devices, white devices which emit white light have a wide scope of applications such as white mono-color display, area color display or full color display comprising combination with color filter, and white illumination. For obtaining white light emission with low-molecular organic EL devices, a method of laminating light-emitting layers emitting different colors by vacuum deposition is employed as disclosed in, for example, "Organic EL and Display", pages 241-250 (published from CMC in 2001). On the other hand, in the case of preparing a laminate structure by wet coating, there is the problem that the previously coated layer is dissolved with solvent in the solution coated later, and the laminate structure cannot be prepared. Therefore, for obtaining white devices of polymer organic EL devices, a method of incorporating a plurality of dyes into a single light-emitting layer at low concentrations has been proposed as disclosed in, for example, "Organic EL and Display", pages 251-257 (published from CMC in 2001). However, white devices produced by this method do not provide sufficient emission efficiency.
Non-Patent Document 1: "Organic Electroluminescence Materials and Display", supervisor: Junji Kido, pages 241-257 (published from CMC in 2001) ISBN4-88231-284-0.
US-2002/0106529 describes an organic-electroluminescence device, a process for its production, and a display system having the device.
EP-A-1705728 describes an electroluminescent apparatus comprising: an OLED device emitting light in the blue and green spectrums; and at least one down conversion layer, said down conversion layer absorbing at least part of the green spectrum light and emitting in at least one of the orange spectrum and red spectrum.
US-A-2004/097101 relates to organic light emitting devices (OLEDs), and more specifically to organic devices having small molecule organic layers fabricated using solution processing.
US-A-2005/186106 relates to an organic electroluminescent device and a process for preparing the same.

### Disclosure of Invention

### Problem to be solved by the Invention

The object of the present invention is to provide a white polymer organic electroluminescent device excellent in device characteristics such as efficiency.

### Means for solving the Problem

As a result of intensive research conducted by the inventors for solving the above problems, it has been found that in laminating light-emitting layers emitting light of different colors for obtaining polymer organic EL devices, white devices of high efficiency can be simply produced by crosslinking at least one of the layers. Thus, the present invention has been accomplished.

That is, the present invention is as follows.
[1] A white organic electroluminescent device which comprises at least two laminated light-emitting layers emitting light of different colors, the light-emitting layers being located between electrodes comprising a positive electrode and a negative electrode, at least one of which electrodes is transparent or translucent, and wherein the light-emitting layers contain a polymer compound as a charge-transporting material or a light-emitting material, at least one of the light-emitting layers being a crosslinked light-emitting layer, which light-emitting layers emit a white light as a whole.
[2] A white organic electroluminescent device described in [1], wherein at least one of the light-emitting layers is a non-crosslinked light-emitting layer, and wherein at least one of the crosslinked light-emitting layers and at least one of the non-crosslinked light-emitting layers are in contact with each other.
[3] A device described in [1] or [2] which is obtained by a method including steps of forming a crosslinkable light-emitting layer by coating, crosslinking the light-emitting layer, and then laminating other light-emitting layer on the crosslinked light-emitting layer.
[4] A device described in any one of [1]-[3], wherein the crosslinking is carried out with a crosslinking agent and the crosslinking agent contains no aromatic ring.
[5] A device described in any one of [1]-[4], wherein the crosslinking agent has a group selected from the group consisting of vinyl group, acetylene group, butenyl group, acryl group, acrylate group, acrylamide group, methacryl group, methacrylate group, methacrylamide group, vinyl ether group, vinylamino group, silanol group, cyclopropyl group, cyclobutyl group, epoxy group, oxetane group, diketene group, episulfide group, lactone group and lactam group.
[6] A device described in any one of [1]-[4], wherein the crosslinking agent is a (meth)acrylate.
[7] A device described in [6], wherein the crosslinking agent is a (meth)acrylate of an aliphatic alcohol.
[8] A device described in [6] or [7], wherein the crosslinking agent is a bi- or higher-functional (meth)acrylate.
[9] A device described in [8], wherein the crosslinking agent is dipentaerythritol penta- or hexa-acrylate.
[10] A device described in any one of [1]-[9], wherein the polymer material is a conjugated polymer compound.
[11] A device described in any one of [1]-[10], wherein the polymer material has a repeating unit derived from an aromatic amine.
[12] A device described in any one of [1]-[11], wherein the colors of lights emitted from at least two light-emitting layers are red and blue.
[13] A planar light source using the device described in any one of [1]-[12].
[14] A segment display apparatus using the device described in any one of [1]-[12].
[15] A dot matrix display apparatus using the device described in any one of [1]-[12] as a backlight.
[16] A liquid crystal display apparatus using the device described in any one of [1]-[12] as a backlight.

### Advantages of the Invention

The white organic electroluminescent device of the present invention emits white light highly efficiently. Furthermore, it can be suitably used in curved or flat plane light sources for backlight of liquid crystal display or illumination, segment type display devices, apparatuses such as flat panel display of dot matrix, etc.

### Best Mode for Carrying Out the Invention

The present white organic electroluminescent device is characterized by comprising at least two laminated light-emitting layers emitting light of different colors, the light-emitting layers being located between electrodes comprising a positive electrode and a negative electrode, at least one of which electrodes is transparent or translucent, and wherein the light-emitting layers contain a polymer charge-transporting material or polymer light-emitting material, at least one of the light-emitting layers being a crosslinked light-emitting layer, which light-emitting layers emit a white light as a whole. The polymer charge-transporting material is a polymer compound as a charge-transporting material and the polymer light-emitting material is a polymer compound as a light-emitting material.

White color is a color sensed by human when all of three kinds of cones of the human retina (red (R), green (G), blue (B)) are uniformly excited. For emitting white light from organic EL devices, there are (i) a method of using the respective emitted lights from three wavelengths of R, G, B and (ii) a method of synthesizing a light of two wavelengths which are in complementary relation of blue + yellow - orange or bluish green + red. In the present invention, emission of white light is attained by the method (i) or (ii) with laminated two or more light-emitting layers emitting light of different colors containing a charge-transporting material or a light-emitting material which is a polymer compound.
The two or more light-emitting layers emitting light of different colors are formed by coating a crosslinkable light-emitting layer, crosslinking the layer, and then laminating other light-emitting layer on the crosslinked light-emitting layer, preferably by wet lamination. The wet lamination is a method of forming a layer which comprises dissolving or dispersing a material which forms the layer in a solvent, and then forming the layer using the resulting solution by coating or the like.
According to the present invention, in wet lamination of two or more light-emitting layers, the previously coated layer is crosslinked to make it insoluble in solvent. The crosslinking may be carried out by adding a crosslinking agent or using a light-emitting layer having a crosslinking group, and the method of adding crosslinking agent is preferred. The light-emitting layer having crosslinking group includes a layer comprising a polymer compound having light-emitting property or charge-transporting property to which a crosslinking group is synthetically added (see US6107452, US2002/106529 (JP-A-2002-170667), WO96/20253 (JP-A-10-511718)). Furthermore, it includes a mixture of a low-molecular compound having light-emitting property or charge-transporting property and a polymer compound having a crosslinking group as disclosed in WO2002/10129 (JP-A-2004-505169) and W02004/100282, and a mixture of a polymer compound having light-emitting property or charge-transporting property and a polymer compound having a crosslinking group or a low-molecular compound having a crosslinking group such as an aromatic bisazide as a crosslinking agent. If the crosslinking agent or crosslinking group has an aromatic ring, there is the possibility of adversely affecting light-emitting property or charge-transporting property inherently possessed by light-emitting material or charge-transporting material, and hence it is preferred to cure the polymer charge-transporting material or polymer light-emitting material using crosslinking agent or crosslinking group having no aromatic ring.
As a laminating method using a means other than crosslinking, there is a method of using solutions having different polarity for adjacent layers.

The crosslinking agent is a monomer compound having a group capable of carrying out polymerization by the actions of heat, light and thermal polymerization initiator or photopolymerization initiator. The group capable of carrying out polymerization is a group which forms a bond between two or more molecules by initiation of polymerization reaction to produce a crosslinked product.
Since the crosslinking agent used in the present invention preferably has no aromatic ring, the crosslinked product also has no aromatic ring. The groups capable of carrying out polymerization include, for example, vinyl group, acetylene group, butenyl group, acryl group, acrylate group, acrylamide group, methacryl group, methacrylate group, methacrylamide group, vinyl ether group, vinylamino group, silanol group, groups having small-membered ring (such as cyclopropyl group, cyclobutyl group, epoxy group, oxetane group, diketene group, and episulfide group), lactone group, lactam group, or groups containing siloxane derivative. In addition to the above groups, there may be used combinations of groups capable of forming ester bond or amide bond such as combinations of ester group with amino group, ester group with hydroxyl group, etc. Monomers having (meth)acrylate group are particularly preferred.
Typical examples of monofunctional monomers having (meth)acrylate group are 2-ethylhexylcarbitol acrylate, 2-hydroxyethyl acrylate, etc. Typical examples of bifunctional monomers having (meth)acrylate group are 1,6-hexanediol di(meth)acrylate, ethylene glycol di(meth)acrylate, neopentyl glycol di(meth)acrylate, triethylene glycol di(meth)acrylate, 3-methylpentanediol di(meth)acrylate, etc. Typical examples of other polyfunctional monomers having (meth)acrylate group are trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, etc. Among them, polyfunctional monomers of bi- or higher-functional monomers are superior in curability and preferred.
The crosslinking agent is contained in an amount of usually 1-99 parts by mass, preferably 1-60 parts by mass, more preferably 5-50 parts by mass for 100 parts by mass in total of the polymer charge-transporting materials or polymer light-emitting materials. When the content of the crosslinking agent is 1-60 parts by mass, smoothness of the coating film tends to be higher, which is preferred.

In the polymerization reaction using the crosslinking agent, if necessary, a photopolymerization initiator can be used. In the case of using the photopolymerization initiator, it is used in an amount of usually about 0.1-40 parts by mass, preferably about 1-30 parts by mass for 100 parts by mass in total of the crosslinking agents. As the photopolymerization initiator, mention may be made of active radical generators generating active radicals, acid generators generating acid upon irradiation with light, and the like. Examples of the active radical generators are acetophenone photopolymerization initiators, benzoin photopolymerization initiators, benzophenone photopolymerization initiators, thioxanthone photopolymerization initiators, triazine photopolymerization initiators, etc.

The acetophenone photopolymerization initiators include, for example, diethoxyacetophenone, 2-hydroxy-2-methyl-1-phenylpropane-1-one, benzyldimethylketal, 2-hydroxy-2-methyl-1-[4-(2-hydroxyethoxy)phenyl]propane-1-one, 1-hydroxycyclohexylphenylketone, 2-methyl-2-morpholino-1-(4-methylthiophenyl)propane-1-one, 2-benzyl-2-dimethylamino-1-(4-morpholinophenyl)butane-1-one, oligomers of 2-hydroxy-2-methyl-1-[4-(1-methylvinyl)phenyl]propane-1-one, etc.

The benzoin photopolymerization initiators include, for example, benzoin, benzoinmethyl ether, benzoinethyl ether, benzoinisopropyl ether, benzoinisobutyl ether, etc.
The benzophenone photopolymerization initiators include, for example, benzophenone, methyl o-benzoylbenzoate, 4-phenylbenzophenone, 4-benzoyl-4'-methyldiphenyl sulfide, 3,3',4,4'-tetra(tert-butylperoxycarbonyl)benzophenone, 2,4,6-trimethylbenzophenone, etc.

The thioxanthone photopolymerization initiators include, for example, 2-isopropylthioxanthone, 4-isopropylthioxanthone, 2,4-diethylthioxanthone, 2,4-dichlorothioxanthone, 1-chloro-4-propoxythioxanthone, etc.

The triazine photopolymerization initiators include, for example,
2,4-bis(trichloromethyl)-6-(4-methoxyphenyl)-1,3,5-triazine,
2,4-bis(trichloromethyl)-6-(4-methoxynaphthyl)-1,3,5-triazine,
2,4-bis(trichloromethyl)-6-piperonyl-1,3,5-triazine, 2,4-bis(trichloromethyl)-6-(4-methoxystyryl-1,3,5-triazine,
2,4-bis(trichloromethyl)-6-[2-(5-methylfuran-2-yl)ethenyl]-1,3,5-triazine,
2,4-bis(trichloromethyl)-6-[2-(furan-2-yl)ethenyl]-1,3,5-triazine,
2,4-bis(trichloromethyl)-6-[2-(4-diethylamino-2-methylphenyl)ethenyl]-1,3,5-triazine, 2,4-bis(trichloromethyl)-6-[2-(3,4-dimethoxyphenyl)ethenyl]-1,3,5-triazine, etc.

As other active radical generators, there may be used, for example, 2,4,6-trimethylbenzoyldiphenylphosphine oxide, 2,2'-bis(o-chlorophenyl)-4,4',5,5'-tetraphenyl-1,2'-biimidazole, 10-butyl-2-chloroacridone, 2-ethylanthraquinone, benzyl, 9,10-phenanthrenequinone, camphorquinone, methyl phenylglyoxylate, titanocene compounds, etc. Commercially available active radical generators can also be used. Examples of the commercially available photopolymerization initiators are Irgacure-907 (trade name for acetophenone photopolymerization initiator manufactured by Ciba-Geigy Corp.), etc.

The acid generators include, for example, onium salts such as 4-hydroxyphenyldimethylsulfonium p-toluenesulfonate, 4-hydroxyphenyldimethylsulfoniumhexafluoro antimonate, 4-acetoxyphenyldimethylsulfonium p-toluenesulfonate, 4-acetoxyphenyl· methyl· benzylsulfoniumhexafluoro antimonate, triphenylsulfonium p-toluenesulfonate, triphenylsulfoniumhexafluoro antimonate, diphenyliodonium p-toluenesulfonate and diphenyliodoniumhexafluoro antimonite, nitrobenzyl tosylates, benzoin tosylates, etc.

Among the compounds described above as active radical generators, there are compounds which generate acids together with active radicals, and, for example, triazine photopolymerization initiators are also used as acid generators.

These photopolymerization initiators may be used each alone or in combination of two or more.

The composition used for producing the devices of the present invention may contain a photopolymerization initiation assistant. The photopolymerization initiation assistant is a compound used in combination with photopolymerization initiator for accelerating the polymerization by crosslinking agent initiated with the photopolymerization initiator. As the photopolymerization initiation assistant, mention may be made of, for example, amine photopolymerization initiation assistants, alkoxyanthracene photopolymerization initiation assistants, etc.

The amine photopolymerization initiation assistants include, for example, triethanolamine, methyldiethanolamine, triisopropanolamine, methyl 4-dimethylaminobenzoate, ethyl 4-dimethylaminobenzoate, isoamyl 4-dimethylaminobenzoate, 2-dimethylaminoethyl benzoate, 2-ethylhexyl 4-dimethylaminobenzoate, N,N-dimethylparatoluidine, 4,4'-bis(dimethylamino)benzophenone (common name: Michler's ketone), 4,4'-bis(diethylamino)benzophenone, 4,4'-bis(ethylmethylamino)benzophenone, etc.

The alkoxyanthracene photopolymerization initiation assistants include, for example, 9,10-dimethoxyanthracene, 2-ethyl-9,10-dimethoxyanthracene, 9,10-diethoxyanthracene, 2-ethyl-9,10-diethoxyanthracene, etc. Commercially available photopolymerization initiation assistants can also be used. Examples of the commercially available photopolymerization initiation assistants are EAB-F (trade name) manufactured by Hodogaya Chemical Co., Ltd., etc.

In the case of using the photopolymerization initiation assistants, it is used in an amount of usually not more than 10 mols, preferably not less than 0.01 mol and not more than 5 mols per 1 mol of photopolymerization initiator. The total amount of the photopolymerization initiator and the photopolymerization initiation assistant is usually not less than 3 parts by mass and not more than 30 parts by mass, preferably not less than 5 parts by mass and not more than 25 parts by mass for 100 parts by mass of the crosslinking agent.

The composition used for production of the device of the present invention may further contain a chain transfer agent. As the chain transfer agent, mention may be made of, for example, 2,4-diphenyl-4-methyl-1-pentene, n-dodecylmercaptan, t-dodecylmercaptan, n-octylmercaptan, limonene, etc. The content of the chain transfer agent is usually not less than 0.5% and not more than 5% by weight fraction based on the total solid matter in the composition of the present invention.

As the thermal polymerization initiators, there may be used those which are generally known as radical polymerization initiators, and examples thereof are azo compounds such as 2,2'-azobisisobutyronitrile, 2,2'-azobis-(2,4-dimethylvaleronitrile), and 2,2'-azobis-(4-methoxy-2,4-dimethylvaleronitrile); organic peroxides such as benzoyl peroxide, lauroyl peroxide, t-butylperoxy pivalate, and 1,1'-bis-(t-butylperoxy)cyclohexane; and hydrogen peroxide. In the case of using a peroxide as the radical polymerization initiator, this may be a redox type initiator by using the peroxide together with a reducing agent.

Next, the polymer charge-transporting material or light-emitting material used for producing the device of the present invention will be explained.
The polymer charge-transporting material or polymer light-emitting material used in the present invention has a number-average molecular weight of usually 10³-10⁸ in terms of polystyrene. Among the polymer charge-transporting material or polymer light-emitting material of the present invention, conjugated polymer compounds are preferred. The conjugated polymer compound here means a polymer compound in which delocalization n electron-pairs are present along the main chain skeleton of the polymer compound. For the delocalization electrons, unpaired electrons or lone electron-pairs sometimes participate in resonance in place of double bond.

The polymer charge-transporting materials or polymer light-emitting materials used in the present invention may be homopolymers or copolymers. They may be, for example, polyarylenes such as polyfluorene [see, for example, "Japanese Journal of Applied Physics (Jpn. J. Appl. Phys.)", Vol.30, L page 1941 (1991)], polyparaphenylene [see, for example, "Advanced Materials (Adv. Mater.)", Vol.4, page 36 (1992)], polypyrrole, polypyridine, polyaniline and polythiophene; polyarylenevinylene such as polyparaphenylenevinylene and polythienylenevinylene (see, for example, WO98/27136); polyphenylene sulfide, polycarbazole, etc. [as general remarks, see, for example, "Advanced Materials", Vol.12, pages 1737-1750 (2000) and "Organic EL Display Technology", (the December special number of "Monthly Display", pages 68-73).

Among them, polyarylene polymer charge-transporting materials or polymer light-emitting materials are preferred.
As the repeating units contained in the polyarylene polymer charge-transporting materials or polymer light-emitting materials, there are arylene groups and divalent heterocyclic groups, and these repeating units are contained in an amount of preferably 20-100 mol%, more preferably 50-99 mol%.
The number of carbons constituting the ring of arylene group is usually about 6-60, and typical examples of the arylene group are phenylene group, biphenylene group, terphenylene group, naphthalenediyl group, anthracenediyl group, phenanthrenediyl group, pentalenediyl group, indenediyl group, heptalenediyl group, indacenediyl group, triphenylenediyl group, binaphthyldiyl group, phenylnaphthylenediyl group, stilbenediyl group, fluorenediyl group (e.g., one represented by the following formula (1) where A is - C(R')(R')-), etc.
The number of carbons constituting the ring of the divalent heterocyclic group is usually about 3-60, and typical examples of the divalent heterocyclic group are pyridinediyl group, diazaphenylene group, quinolinediyl group, quinoxalenediyl group, acridinediyl group, bipyridyldiyl group, phenathrolinediyl group, and a group represented by the following formula (1) where A is -O-, -S-, -Se-, -NR"-, -C(R')(R')- or -Si(R')-(R')-.

Further preferred are those which contain the repeating unit represented the following formula (1). 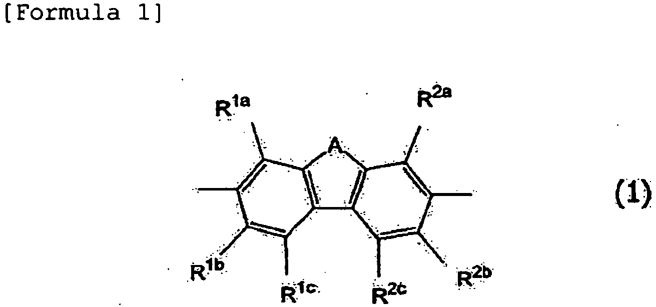 (where A represents an atom or a group of atoms which complete a 5-membered ring or 6-membered ring together with the four carbon atoms on the two benzene rings, R^{1a}, R^{1b}, R^{1c}, R^{2a}, R^{2b} and R^{2c} independently represent hydrogen atom, halogen atom, alkyl group, alkyloxy group, alkylthio group, aryl group, aryloxy group, arylthio group, arylalkyl group, arylalkyloxy group, arylalkylthio group, alkenyl group, alkynyl group, arylalkenyl group, arylalkynyl group, acyl group, acyloxy group, amide group, acid imide group, imine residue, substituted amino group, substituted silyl group, substituted silyloxy group, substituted silylthio group, substituted silylamino group, cyano group, nitro group, monovalent heterocyclic group, heteroaryloxy group, heteroarylthio group, alkyloxycarbonyl group, aryloxycarbonyl group, arylalkyloxycarbonyl group, heteroaryloxycarbonyl group or carboxyl group, and R^{1b} and R^{1c}, and R^{2b} and R^{2c} may form together a ring, respectively).

A represents an atom or a group of atoms which complete a 5-membered ring or 6-membered ring together with the four carbon atoms on the two benzene rings in the formula (1), and typical examples thereof are shown below, which should not be construed as limiting the invention.

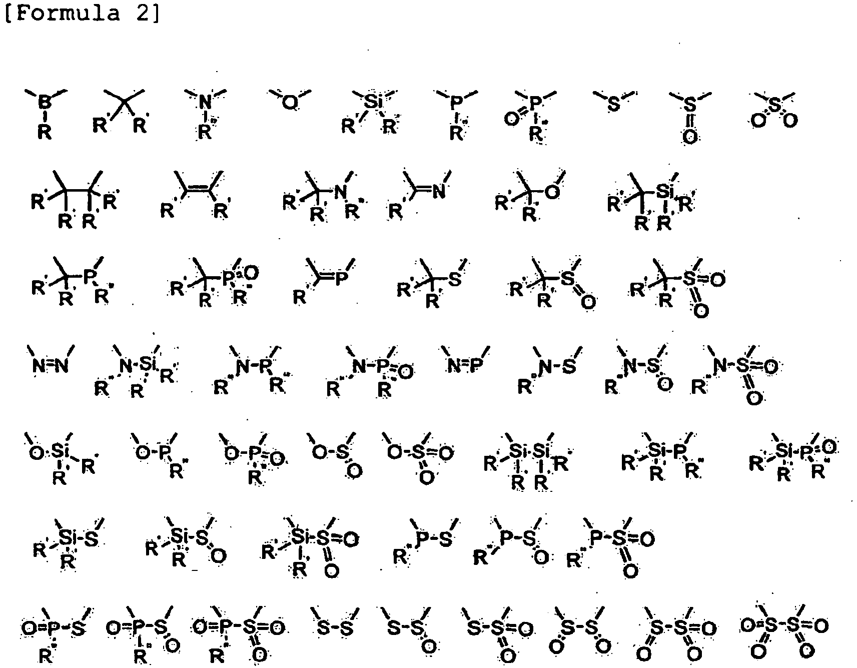

In the above formulas, R, R' and R" independently represent halogen atom, alkyl group, alkyloxy group, alkylthio group, aryl group, aryloxy group, arylthio group, arylalkyl group, arylalkyloxy group, arylalkylthio group, alkenyl group, alkynyl group, arylalkenyl group, arylalkynyl group, acyloxy group, substituted amino group, substituted silyloxy group, substituted silylthio group, substituted silylamino group, cyano group or monovalent heterocyclic group. R' independently represent hydrogen atom, halogen atom, alkyl group, alkyloxy group, alkylthio group, aryl group, aryloxy group, arylthio group, arylalkyl group, arylalkyloxy group, arylalkylthio group, alkenyl group, alkynyl group, arylalkenyl group, arylalkynyl group, acyl group, acyloxy group, amide group, acid imide group, imine residue, substituted amino group, substituted silyl group, substituted silyloxy group, substituted silylthio group, substituted silylamino group, cyano group, nitro group or monovalent heterocyclic group. R" independently represent hydrogen atom, alkyl group, alkyloxy group, alkylthio group, aryl group, aryloxy group, arylthio group, arylalkyl group, arylalkyloxy group, arylalkylthio group, alkenyl group, alkynyl group, arylalkenyl group, arylalkynyl group, acyl group, substituted silyl group, substituted silyloxy group, substituted silylthio group, substituted silylamino group or monovalent heterocyclic group.

Definitions and examples of halogen atom, alkyl group, alkyloxy group, alkylthio group, aryl group, aryloxy group, arylthio group, arylalkyl group, arylalkyloxy group, arylalkylthio group, alkenyl group, alkynyl group, arylalkenyl group, arylalkynyl group, substituted silyloxy group, substituted silylthio group, substituted silylamino group, substituted amino group, amide group, acid imide group, acyl group, acyloxy group and monovalent heterocyclic group of R, R' and R" are the same as those given on R^{1a}, R^{1b}, R^{1c}, R^{2a}, R^{2b} and R^{2c}.
A is preferably -O-, -S-, -Se-, -NR"-, - CR'R'- or -SiR'R', more preferably -O-, -S- or -CR'R'-.
The halogen atom, alkyl group, alkyloxy group, alkylthio group, aryl group, aryloxy group, arylthio group, arylalkyl group, arylalkyloxy group, arylalkylthio group, alkenyl group, alkynyl group, arylalkenyl group, arylalkynyl group, acyl group, acyloxy group, amide group, acid imide group, imine residue, substituted amino group, substituted silyl group, substituted silyloxy group, substituted silylthio group, substituted silylamino group, cyano group, nitro group, monovalent heterocyclic group, heteroaryloxy group, heteroarylthio group, alkyloxycarbonyl group, aryloxycarbonyl group, arylalkyloxycarbonyl group and heteroaryloxycarbonyl group of R^{1a}, R^{1b}, R^{1c}, R^{2a}, R^{2b} and R^{2c} are the same as mentioned hereinabove.

As the repeating unit represented by the above formula (1), the following structures can be exemplified.

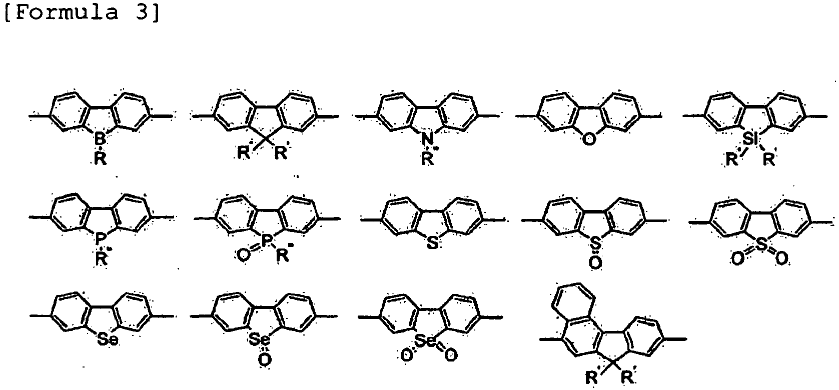

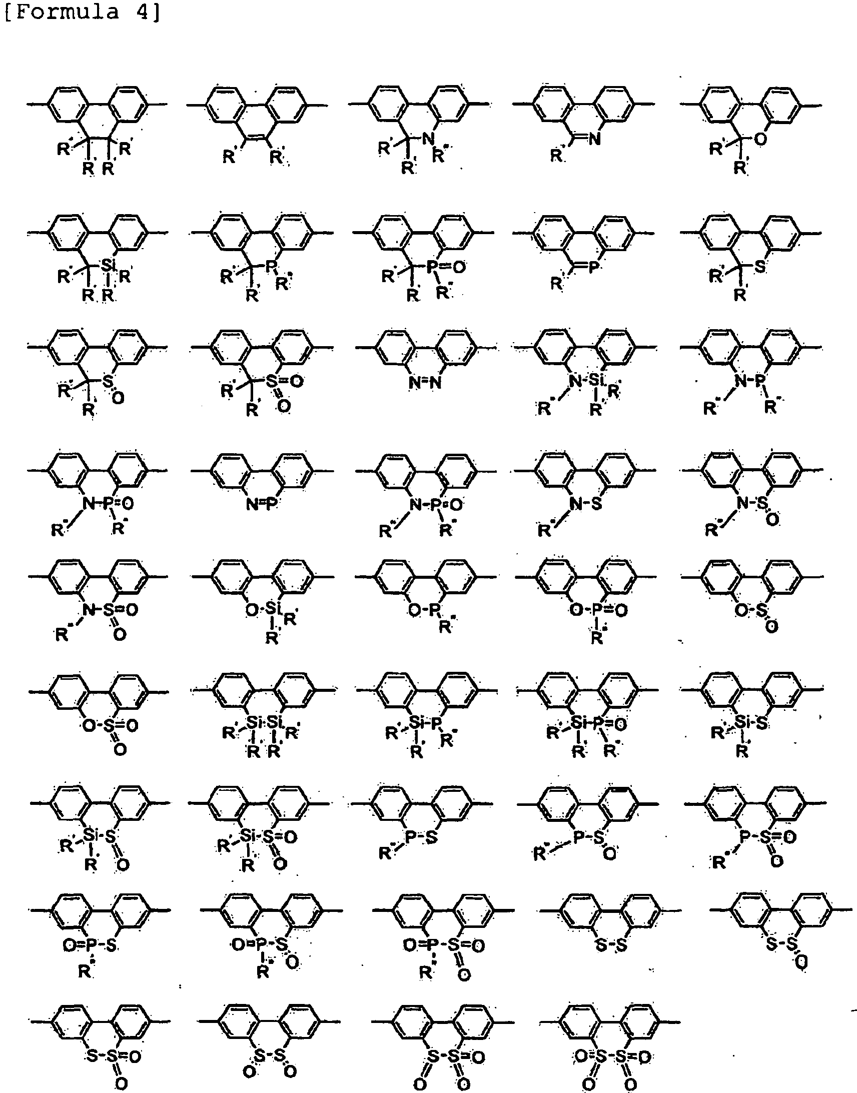

In the above formulas, hydrogen atoms on the benzene rings may be substituted with halogen atom, alkyl group, alkyloxy group, alkylthio group, aryl group, aryloxy group, arylthio group, arylalkyl group, arylalkyloxy group, arylalkylthio group, alkenyl group, alkynyl group, arylalkenyl group, arylalkynyl group, acyl group, acyloxy group, amide group, acid imide group, imine residue, substituted amino group, substituted silyl group, substituted silyloxy group, substituted silylthio group, substituted silylamino group, cyano group, nitro group or monovalent heterocyclic group. When two substituents are present at adjacent positions of benzene ring, they may link with each other to form a ring.

The polymer charge-transporting material or polymer light-emitting material used in the present invention may contain, for example, repeating units derived from aromatic amines in addition to arylene group and divalent heterocyclic group. In this case, hole injecting or transporting property can be imparted to the polymer charge-transporting material or polymer light-emitting material.
In this case, the molar ratio of the repeating unit comprising arylene group or divalent heterocyclic group and the repeating unit derived from aromatic amine is usually in the range of 99:1-20:80.

A repeating unit represented by the following formula (2) is preferred as the repeating unit derived from aromatic amine.

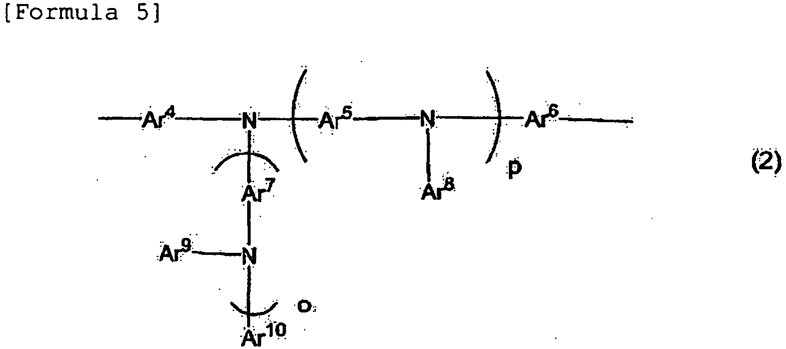

In the above formula, Ar⁴, Ar⁵, Ar⁶ and Ar⁷ independently represent an arylene group or a divalent heterocyclic group, Ar⁸, Ar⁹ and Ar¹⁰ independently represent an aryl group or a monovalent heterocyclic group, and o and p independently represent 0 or 1 and satisfy the formula 0≦o+p≦2.

Definitions and examples of the arylene group and divalent heterocyclic group are the same as those mentioned hereinabove. Definitions and examples of the aryl group and monovalent heterocyclic group are the same as those mentioned hereinabove on R^{1a}, R^{1b}, R^{1c}, R^{2a}, R^{2b} and R^{2c}.

Typical examples of the repeating unit represented by the above formula (2) are the following structures.

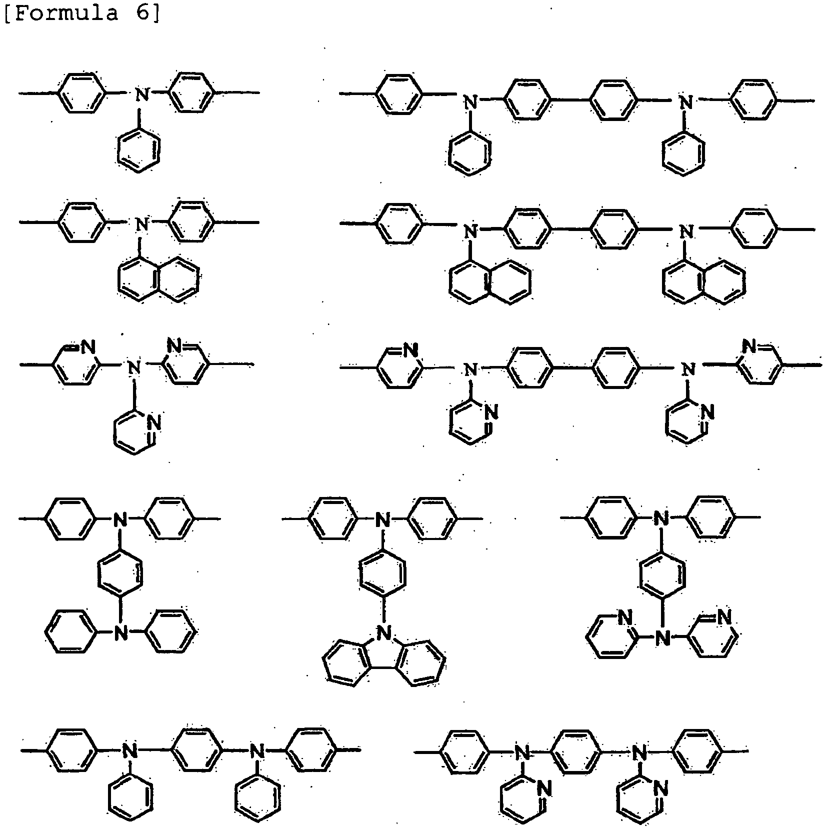

In the above formulas, hydrogen atoms on the aromatic rings may be substituted with substituents selected from halogen atom, alkyl group, alkyloxy group, alkylthio group, aryl group, aryloxy group, arylthio group, arylalkyl group, arylalkyloxy group, arylalkylthio group, alkenyl group, alkynyl group, arylalkenyl group, arylalkynyl group, acyl group, acyloxy group, amide group, acid imide group, imine residue, substituted amino group, substituted silyl group, substituted silyloxy group, substituted silylthio group, substituted silylamino group, cyano group, nitro group, monovalent heterocyclic group, heteroaryloxy group, heteroarylthio group, alkyloxycarbonyl group, aryloxycarbonyl group, arylalkyloxycarbonyl group, heteroaryloxycarbonyl group and carboxyl group.

Of the repeating units represented by the above formula (2), especially preferred are those which are represented by the following formula (3).

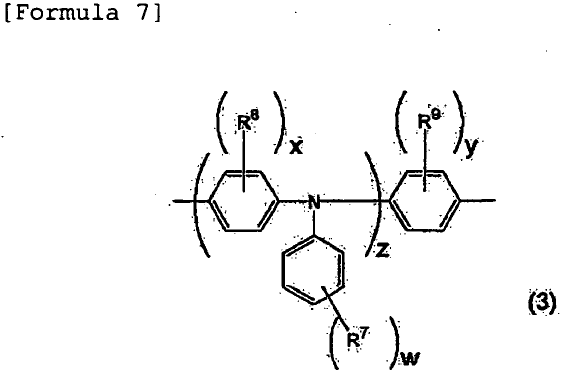

In the above formula, R⁷, R⁸ and R⁹ independently represent halogen atom, alkyl group, alkyloxy group, alkylthio group, aryl group, aryloxy group, arylthio group, arylalkyl group, arylalkyloxy group, arylalkylthio group, alkenyl group, alkynyl group, arylalkenyl group, arylalkynyl group, acyl group, acyloxy group, amide group, acid imide group, imine residue, substituted amino group, substituted silyl group, substituted silyloxy group, substituted silylthio group, substituted silylamino group, cyano group, nitro group, monovalent heterocyclic group, heteroaryloxy group, heteroarylthio group, alkyloxycarbonyl group, aryloxycarbonyl group, arylalkyloxycarbonyl group, heteroaryloxycarbonyl group or carboxyl group, x and y independently represent an integer of 0-4, z represents an integer of 0-2, and w represents an integer of 0-5.

The polymer charge-transporting material or polymer light-emitting material used in the present invention may be a random, block or graft copolymer, or a polymer having intermediate structure of these polymers, for example, a random copolymer with blocks. For obtaining a polymer light-emitting material high in quantum yield of light emission, a random copolymer with blocks, or block or graft copolymer is preferable to a complete random copolymer. There are also included copolymers which have branches on main chain or have three or more end portions, and dendrimers.

If a polymerization active group remains as it is in the end group of the polymer charge-transporting material or polymer light-emitting material used in the present invention, emission characteristics or life of devices obtained tend to deteriorate, and hence the end group may be protected with a stable group. Preferred are those which have conjugated bonds continuous to conjugated structure of main chain, and there may be exemplified, for example, a structure in which the conjugated bonds are bonded to aryl group or heterocyclic group through carbon-carbon bond. Specific examples are substituents shown by Formula 10 of JP-A-9-45478.

The polymer charge-transporting material or polymer light-emitting material used in the present invention has a number-average molecular weight of preferably about 10³-10⁸, more preferably about 10⁴-10⁶ in terms of polystyrene.

Furthermore, since light emission from thin film is utilized, there may be suitably used a polymer light-emitting material which emits light in the state of solid.

As methods for preparing the polymer charge-transporting material or polymer light-emitting material used in the present invention, mention may be made of, for example, a method of polymerization of corresponding monomers by Suzuki coupling reaction, by Grignard reaction, by using Ni(O) catalyst, by using an oxidizing agent such as FeCl₃, by electrochemical oxidative polymerization, or by decomposition of intermediate polymer having a suitable elimination group. Of these methods, the method of polymerization by Suzuki coupling reaction, the method of polymerization by Grignard reaction, and the method of polymerization by using Ni(O) catalyst are preferred because the reaction can be easily controlled.
In the case of using the polymer light-emitting material as a light emitting material of polymer LED, since the purity affects the light emission characteristics, it is preferred to purify the monomers before polymerization by distillation, sublimation purification, recrystallization, or the like and then polymerize the monomers, or to purify after polymerization by reprecipitation purification, fractionation by chromatography, or the like.

Examples of solvent are chloroform, methylene chloride, dichloroethane, tetrahydrofuran, toluene, xylene, mesitylene, tetralin, decalin, n-butylbenzene, etc. Although it depends on the structure or molecular weight of the polymer charge-transporting material or polymer light-emitting material, usually 0.1% by weight or more of the material can be dissolved in these solvents.

The amount of the solvent is usually about 1000-100000 parts by weight for 100 parts by weight of the polymer charge-transporting material or polymer light-emitting material.

In addition to the polymer charge-transporting material or polymer light-emitting material, if necessary, there may be contained in admixture a light-emitting dye and charge-transporting material which are low-molecular or oligomer or dendrimer.

As polymer hole-transporting materials among the polymer charge-transporting materials, mention may be made of, for example, polyvinylcarbazole or derivatives thereof, polysilane or derivatives thereof, polysiloxane derivatives having aromatic amine on side chain or main chain, pyrazoline derivatives, arylamine derivatives, stilbene derivatives, triphenyldiamine derivatives, polyaniline or derivatives thereof, polythiophene or derivatives thereof, polypyrrole or derivatives thereof, poly(p-phenylenevinylene) or derivatives thereof, poly(2,5-thienylenevinylene) or derivatives thereof, etc.

Specific examples of the hole-transporting materials are those which are disclosed in JP-A-63-70257, JP-A-63-175860, JP-A-2-135359, JP-A-2-135361, JP-A-2-209988, JP-A-3-37992, and JP-A-3-152184.

Polyvinylcarbazole or derivatives thereof are obtained, for example, from vinyl monomers by cationic polymerization or radical polymerization.

As polysilane or derivatives thereof, mention may be made of, for example, the compounds which are disclosed in "Chemical Review (Chem. Rev.)", Vol.89, page 1359 (1989) and GB2300196 (laid-open specification). The methods of synthesis disclosed in these documents can be used, and particularly suitable is the Kipping method.

As the polysiloxane or derivatives thereof, there may be suitably used those which have a structure of the above low-molecular hole-transporting material on side chain or main chain because siloxane skeleton structure has substantially no hole-transporting property. Particularly suitable are those which have hole-transporting aromatic amine on side chain or main chain.

As the polymer hole-transporting materials, particularly preferred are polymer compounds comprising repeating units derived from aromatic amines. As for the repeating units derived from aromatic amines, those which are represented by the above formula (2) are preferred, and those which are represented by the above formula (3) are more preferred.

Among the polymer charge-transporting materials, as polymer electron-transporting materials, there may be used known ones, and examples thereof are polyquinoline or derivatives thereof, polyquinoxaline or derivatives thereof, polyfluorene or derivatives thereof, etc.

When the polymer compound used in the present invention is used in organic EL devices, since the purity affects performance of devices such as light emission characteristics, it is preferred that monomers before polymerization are purified by distillation, sublimation purification, recrystallization, column chromatography or the like, and then the purified monomers are polymerized. Furthermore, it is preferred to purify the resulting polymers by common separation operations, purification operations, drying and other operations such as acid washing, alkali washing, neutralization, water washing, organic solvent washing, reprecipitation, centrifugal separation, extraction, column chromatography and dialysis.

The polymer composition used for producing the devices of the present invention contains the polymer charge-transporting material. In case layer is crosslinked to make it insoluble in solvent, the composition preferably contains the above-mentioned crosslinking agent. Usually, the composition of the present invention further contains a solvent. In addition, it may contain additives such as charge-transporting material, light-emitting material, surface active agent and stabilizer. The proportion of the polymer charge- transporting material or polymer light-emitting material in the composition is 20-100% by weight, preferably 40-100% by weight based on the total weight of the composition excluding the solvent.
The proportion of the solvent in the composition used for production of the devices of the present invention is 1-99.9% by weight, preferably 60-99.5% by weight, further preferably 80-99.0% by weight based on the total weight of the composition.

As method for making film from the polymer composition used for production of the devices of the present invention, there may be employed coating methods such as spin coating method, casting method, micro-gravure coating method, gravure coating method, bar coating method, roll coating method, wire bar coating method, dip coating method, spray coating method, screen printing method, flexographic printing method, offset printing method, and ink jet printing method. For easy formation of patterns and easy coating of multi-colors, preferred are printing methods such as screen printing method, flexographic printing method, offset printing method and ink jet printing method.

The viscosity of the polymer composition used for production of devices of the present invention which varies depending on the printing method is preferably 1-20 mPa· s at 25°C for inhibition of clogging of discharging apparatus or curved flying of the composition at discharging in the case of, for example, ink jet printing method in which the ink composition passes through a discharging apparatus.

There is no particular limitation in solvent used for polymer composition used for production of the device of the present invention, and the solvent is preferably one which can dissolve or uniformly disperse the materials other than solvent constituting the composition. When the materials constituting the composition are soluble in non-polar solvent, examples of the solvent are chlorine-based solvents such as chloroform, methylene chloride and dichloroethane, ether solvents such as tetrahydrofuran, aromatic hydrocarbon solvents such as toluene, xylene, tetralin, anisole, n-hexylbenzene and cyclohexylbenzene, aliphatic hydrocarbon solvents such as decalin and bicyclohexyl, ketone solvents such as acetone, methyl ethyl ketone and 2-heptanone, and ester solvents such as ethyl acetate, butyl acetate, ethyl cellosolve acetate and propylene glycol monomethyl ether acetate.

The layer of film formed using the polymer composition used for production of the device of the present invention can be inhibited from dissolution during wet coating of an upper layer by curing the film with heat or light. When the wet coated upper layer is further wet coated with a layer, it is preferred to use the polymer composition for also the upper layer and cure the layer. When the wet coated upper layer is not further wet coated, there is no possibility of being dissolved, and hence the upper layer may comprise a composition containing no crosslinking agent.

In the organic EL device produced using the polymer composition used for producing the device of the present invention, thickness of the charge-transporting layer or light-emitting layer varies in its optimum value depending on the material used, and may be selected so that the driving voltage and light emission efficiency can have proper values. The thickness is, for example, 1 nm - 1 µm, preferably 2-500 nm, more preferably 5-200 nm.

Furthermore, the organic EL device of the present invention is characterized by having a charge-transporting layer or a light-emitting layer between electrodes comprising a positive electrode and a negative electrode, said light-emitting layer being formed by laminating at least two light-emitting layers which emit light of different colors. In this case, the light-emitting layer may serve for the charge-transporting layer, too. For attaining white light emission by lamination, there are, for example, a method of laminating three layers emitting the lights of the three wavelengths of R, G, B, respectively, and a method of laminating two layers emitting lights of two wavelengths which are in complementary relation such as blue + yellow - orange or bluish green + red.

In the organic EL device of the present invention, a mixture of the polymer light-emitting material with other light-emitting materials may be used for the light-emitting layer.

As the light-emitting material, known materials can be used. As fluorescent materials of low-molecular compound, there may be used, for example, naphthalene derivatives, anthracene or derivatives thereof, perylene or derivatives thereof, dyes such as polymethine dyes, xanthene dyes, coumalin dyes and cyanine dyes, metal complexes of 8-hydroxyquinolin or derivatives thereof, aromatic amines, tetraphenylcyclopentadiene or derivatives thereof, tetraphenylbutadiene or derivatives thereof, etc. Specifically, there may be used known materials disclosed, for example, in JP-A-57-51781 and JP-A-59-194393.

As triplet light-emitting complexes, mention may be made of, for example, Ir(ppy)₃ and Btp₂Ir(acac) having iridium as a central metal, PtOEP having platinum as a central metal, Eu(TTA)₃phen having europium as a central metal, etc.

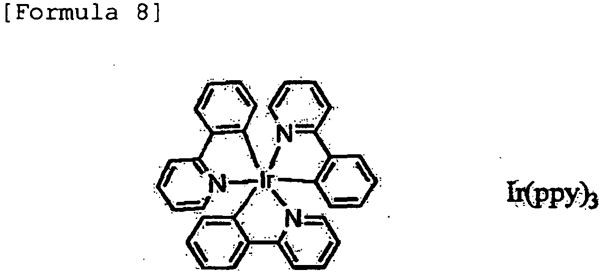

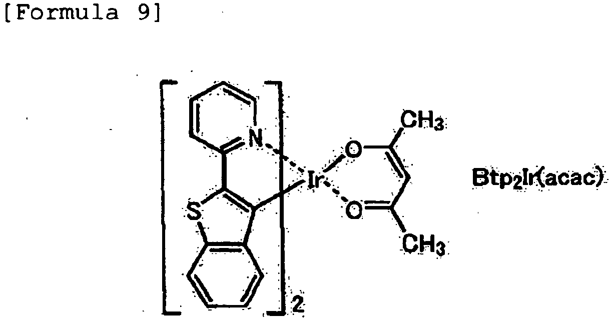

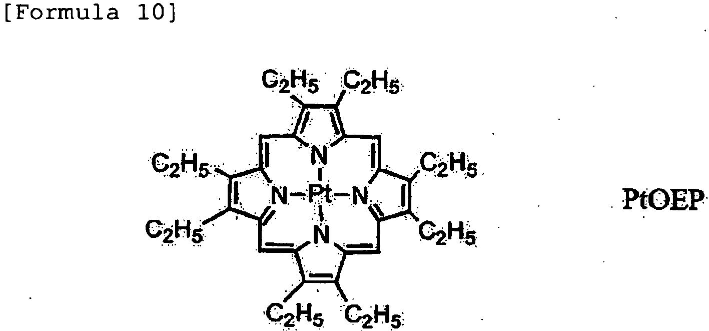

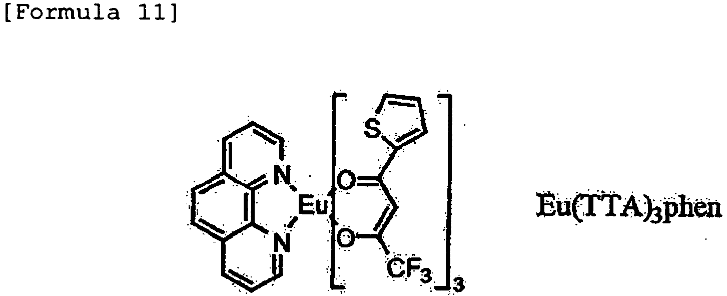

Specific examples of the triplet light-emitting complexes are as disclosed, for example, in Nature, (1998), 395, 151, Appl. Phys. Lett. (1999), 75(1), 4, Proc. SPIE-Int. Soc. Opt. Eng. (2001), 4105 (Organic Light-Emitting Materials and Devices IV), 119, J. Am. Chem. Soc., (2001), 123, 4304, Appl. Phys. Lett., (1997), 71(18), 2596, Syn. Met., (1998), 94(1), 103, Syn. Met., (1999), 99(2), 1361, Adv. Mater., (1999), 11(10), 852, Jpn. J. Appl. Phys., 34, 1883 (1995), etc.

Substrates for forming the organic EL device of the present invention can be those which do not change when electrodes are formed and organic layer is formed, and examples thereof are glass substrates, plastic substrates, polymeric film substrates, silicon substrates, etc. In the case of using an opaque substrate, the opposite electrode is preferably transparent or translucent.

In the organic EL device of the present invention, usually, at least one of electrodes comprising a positive electrode and a negative electrode is transparent or translucent, and, preferably, the positive electrode is transparent or translucent. As materials of the positive electrode, electrically conductive metal oxide film, translucent metal thin film, etc. are used. Specifically, indium oxide, zinc oxide, tin oxide or a composite thereof such as indium· tin· oxide (ITO), a film made using electrically conductive glass comprising indium· zinc· oxide and so on (such as NESA), or gold, platinum, silver, copper, or the like is used and ITO, indium· zinc· oxide and tin oxide are preferred. As method for making the positive electrode, there may be used vacuum deposition method, sputtering method, ionic plating method, plating method, etc. Furthermore, transparent conductive films of organic materials such as polyaniline or derivatives thereof and polythiophene or derivatives thereof may be used as the positive electrode.

Thickness of the positive electrode can be optionally selected considering light transmittance and electric conductivity, and is, for example, 10 nm - 10 µm, preferably 20 nm - 1 µm, more preferably 50 nm - 500 nm.

Moreover, for attaining easy charge injection, there may be provided on the positive electrode a layer of 2 nm or less in average thickness which comprises phthalocyanine derivative, electrically conductive polymer, carbon, metal oxide, metal fluoride, organic insulation material or the like.

The materials of negative electrode used in the organic EL device produced using the polymer composition of the present invention are preferably those which are small in work function. There may be used, for example, metals such as lithium, sodium, potassium, rubidium, cesium, beryllium, magnesium, calcium, strontium, barium, aluminum, scandium, vanadium, zinc, yttrium, indium, cerium, samarium, europium, terbium and ytterbium, or alloys of two or more of them or alloys of one or more of them with one or more of gold, silver, platinum, copper, manganese, titanium, cobalt, nickel, tungsten and tin, or graphite or graphite intercalation compounds. Examples of the alloys are magnesium-silver alloys, magnesium-indium alloys, magnesium-aluminum alloys, indium-silver alloys, lithium-aluminum alloys, lithium-magnesium alloys, lithium-indium alloys, calcium-aluminum alloys, etc. The negative electrode may be of laminate structure comprising two or more layers.

Thickness of the negative electrode can be optionally selected considering electric conductivity and endurance, and is, for example, 10 nm - 10 µm, preferably 20 nm - 1 µm, more preferably 50 nm - 500 nm.

For making the negative electrode, vacuum deposition method, sputtering method, lamination method of hot pressing a metal thin film, and others are used. Furthermore, there may be provided between the negative electrode and the layer of organic material a layer having an average thickness of 2 nm or less which comprises electrically conductive polymer, metal oxide, metal fluoride, organic insulation material or the like, and besides, after making the negative electrode, a protective layer protecting the polymer LED may be provided. In order to use the polymer LED stably for a long period of time, preferably a protective layer and/or a protective cover are provided for protecting the device from outside.

As the protective layer, polymer compound, metal oxide, metal fluoride, metal boride, and the like can be used. As the protective cover, glass plate, plastic plate the surface of which is subjected to low water permeability treatment, and the like, can be used, and a method is suitably used which comprises laminating the cover with the device substrate with a thermosetting resin or a photo-setting resin to perform sealing. When a space is maintained using a spacer, the device can be easily prevented from being damaged. If an inert gas such as nitrogen or argon is enclosed in the space, oxidation of the negative electrode can be inhibited, and besides, by placing a drying agent such as barium oxide in the space, it becomes easy to inhibit the device from being damaged with water adsorbed during production step. It is preferred to employ one or more means mentioned above.

The organic EL device of the present invention can be used as planar light source, and backlight of segment display apparatus, dot matrix display apparatus, liquid crystal display apparatus, and the like.

For obtaining planar light emission using the organic EL device of the present invention, planar positive electrode and negative electrode can be disposed one upon another. For obtaining patterned light emission, there are a method of providing a mask having a patterned window on the surface of the planar light-emitting device, a method of forming the layer of organic material of non-light emitting part in an extremely great thickness to make the layer substantially non-light emitting, and a method of forming one or both of the positive electrode and negative electrode in the form of pattern. When the pattern is formed by one of these methods and some electrodes are disposed so that they can be independently on-off controlled, a segment type display device which can display figures, letters and simple marks is obtained. For obtaining a dot matrix device, both the positive electrode and the negative electrode can be formed in stripes and disposed to cross each other. Partial color display and multi-color display can be attained by using color filter or light-emission transforming filter. The dot matrix device can be passively driven or actively driven in combination with TFT. These display devices can be used as display apparatuses of computers, televisions, portable terminals, portable telephones, car navigations, view finders of video cameras.

### Examples

The present invention will be explained in more details by the following examples, which should not be construed as limiting the invention.
The number-average molecular weight in terms of polystyrene is obtained by SEC. Column: TOSOH TSKgel SuperHM-H (two columns) + TSKgel SuperH2000 (4.6 mm I.d. x 15 cm) and detector: RI (SHIMADZU RID-10A) were used. Tetrahydrofuran (THF) was used as mobile phase.

### Synthesis Example 1

### <Synthesis of polymer compound 1>

N,N'-bis(4-bromophenyl)-N,N'-bis(4-n-butylphenyl)-1,4-phenylenediamine (3.3 g, 4.8 mmols) and 2,2'-bipyridyl (1.9 g, 12 mmols) were dissolved in 132 mL of dehydrated tetrahydrofuran, and then the solution was subjected to bubbling with nitrogen to replace the atmosphere of the system with nitrogen. In the nitrogen atmosphere, to this solution was added bis(1,5-cyclooctadiene)nickel (0) {Ni(COD)₂} (3.3 g, 12 mmols), followed by heating to 60°C and carrying out reaction with stirring for 3.5 hours. After completion of the reaction, the reaction mixture was cooled to room temperature (about 25°C) and dropped in a mixed solution comprising 30 mL of 25% aqueous ammonia/480 mL of methanol/160 mL of ion-exchanged water, followed by stirring for 1 hour. The resulting precipitate was filtered and dried for 2 hours under reduced pressure and dissolved in 150 mL of toluene. Thereafter, 120 g of 1N hydrochloric acid was added to the solution, followed by stirring for 3 hours. The aqueous layer was removed, and 140 mL of 25% aqueous ammonia was added to the organic layer, followed by stirring for 3 hours and then removing the aqueous layer. The organic layer was washed twice with 600 mL of water. The organic layer was divided in two, and each of them was dropped in 600 mL of methanol, followed by stirring for 1 hour. The resulting precipitate was filtered and dried for 2 hours under reduced pressure. The yield of the resulting polymer (hereinafter referred to as "polymer compound 1") was 3.26 g. The polymer had an average molecular weight Mn of 1.6 x 10⁴, and a weight-average molecular weight Mw of 1.2 x 10⁵ in terms of polystyrene. The polymer compound in the form of thin film emitted blue light of 434 nm.

### Synthesis Example 2

### <Synthesis of polymer compound 2>

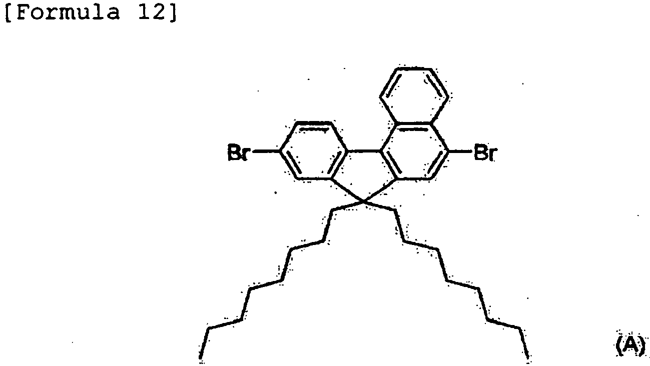

22.5 g of the compound A and 17.6 g of 2,2'-bipyridyl were charged in a reaction vessel, and then the atmosphere in the reaction system was replaced with nitrogen gas. Thereto was added 1500 g of tetrahydrofuran (dehydration catalyst) previously deaerated by bubbling with argon gas. Then, to this mixed solution was added 31 g of bis(1,5-cyclooctadiene)nickel(o), followed by stirring at room temperature for 10 minutes and then carrying out reaction at 60°C for 3 hours. The reaction was carried out in an atmosphere of nitrogen gas.
After completion of the reaction, the reaction mixture was cooled, and therein was poured a mixed solution comprising 200 mL of 25% aqueous ammonia/900 mL of methanol/900 mL of ion-exchanged water, followed by stirring for about 1 hour. Then, the resulting precipitate was filtered and recovered. This precipitate was dried under reduced pressure and dissolved in toluene. The toluene solution was filtered to remove insoluble matters, and then the toluene solution was passed through a column packed with alumina to purify the solution. Thereafter, the toluene solution was washed with a 1N aqueous hydrochloric acid solution, and left to stand and subjected to separation, and then the toluene solution was recovered. Then, the toluene solution was washed with about 3% aqueous ammonia, and left to stand and subjected to separation, and then the toluene solution was recovered. Then, this toluene solution was washed with ion-exchanged water, and left to stand and subjected to separation, and then the toluene solution was recovered. Subsequently, the toluene solution was poured into methanol to carry out re-precipitation.
Then, the resulting precipitate was recovered and washed with methanol, and then the precipitate was dried under reduced pressure to obtain 6.0 g of a polymer. This polymer was referred to as polymer compound 2. The resulting polymer compound 2 had a weight-average molecular weight of 8.2 x 10⁵, and a number-average molecular weight of 1.0 x 10⁵ in terms of polystyrene. The polymer compound in the form of a thin film emitted blue light of 450 nm.

### Synthesis Example 3

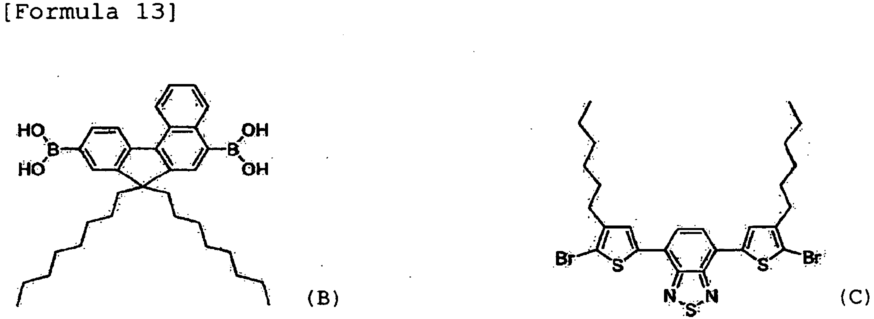

### <Synthesis of polymer compound 3>

The compound B (10000mg, 14.438 mmols) and the compound C (8615 mg, 13.750 mmols) were dissolved in toluene (253 g) in an inert atmosphere, and to the solution was added tetrakis(triphenylphosphine) palladium (318 mg, 0.275 mmols), followed by stirring at room temperature for 10 minutes. Subsequently, to the reaction mixture was added 20% aqueous tetraethylammonium hydroxide solution (49.6 g), followed by heating and refluxing under heating for 13 hours. After completion of the reaction, phenylboronic acid (2515 mg) was added to the reaction mixture, followed by further refluxing under heating for 1 hour. Thereafter, the reaction mixture was cooled to room temperature, the reaction mass was dropped in methanol (2393 ml), and the resulting precipitate was filtered off. The precipitate obtained was washed with methanol and dried under reduced pressure to obtain a solid.
The resulting solid was dissolved in toluene (598 ml), passed through a column packed with silica and alumina, and then concentrated. The concentrated liquid was added to methanol (2393 ml), followed by stirring for 1 hour, and the resulting precipitate was filtered off. The precipitate obtained was washed with methanol and dried under reduced pressure to obtain a polymer compound 3. Yield was 8880 mg. The resulting polymer compound 3 had molecular weight of Mw=40,000 and Mn=20,000 in terms of polystyrene. The polymer compound in the form of a thin film emitted light of orange color of 610 nm.

### <Synthesis of polymer compound 4>

0.91 g of Aliquat 336, 5.23 g of the following compound D and 4.55 g of the following compound E were charged in a 200 ml separable flask, and the atmosphere in the flask was replaced with nitrogen. To the flask was added 70 ml of toluene, and thereto were added 2.0 mg of palladium acetate and 15.1 mg of tris(o-tolyl)phosphine, followed by refluxing. After dropping 19 ml of an aqueous sodium carbonate solution therein, stirring was carried out all night under refluxing, and then 0.12 g of phenylboric acid was added, followed by stirring for 7 hours. 300 ml of toluene was added thereto, and the reaction mixture was subjected to separation. The organic phase was washed with aqueous acetic acid solution and water, and then aqueous sodium N,N-diethyldithiocarbamate solution was added, followed by stirring for 4 hours. After separation, the organic phase was passed through a silica gel-alumina column, and washed with toluene. It was dropped in methanol to precipitate a polymer. After filtration and drying under reduced pressure, the polymer was dissolved in toluene, and the resulting toluene solution was dropped in methanol to precipitate the polymer. The polymer was filtered and dried under reduced pressure to obtain 6.33 g of a polymer compound 4. The polymer compound 4 had Mn=8.8 x 10⁴, and Mw=3.2 x 10⁵. The polymer compound in the form of a thin film emitted light of blue color of 434 nm.

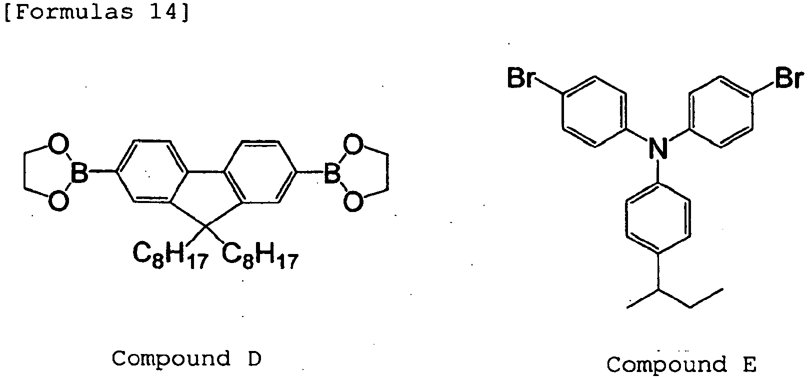

### <Synthesis of polymer compound 5>

1.72 g of Aliquat 336, 6.2171 g of the compound D, 0.5085 g of the following compound F, 6.2225 g of the following compound G and 0.5487 g of the following compound H were charged in a 4-necked flask of 500 ml, and the atmosphere in the flask was replaced with nitrogen. To the flask was added 100 ml of toluene, and thereto were added 7.6 mg of dichlorobis(triphenylphosphine)palladium (II) and 24 ml of aqueous sodium carbonate solution, followed by stirring for 3 hours under refluxing. Thereafter, 0.40 g of phenylboronic acid was added, followed by stirring all night. An aqueous sodium N,N-diethyldithiocarbamate solution was added, followed by further stirring for 3 hours under refluxing. The reaction mixture was subjected to separation, and the organic phase was washed with aqueous acetic acid solution and water, and then was dropped in methanol to precipitate a polymer. After filtration and drying under reduced pressure, the polymer was dissolved in toluene and the solution was passed through a silica gel-alumina column and washed with toluene. The resulting toluene solution was dropped in methanol to precipitate the polymer. After filtration and drying under reduced pressure, the polymer was dissolved in toluene and the solution was dropped in methanol to precipitate the polymer. The polymer was filtered and dried under reduced pressure to obtain 7.72 g of a polymer compound 5. The polymer compound 5 had Mn = 1.2 × 10⁵, and Mw = 2.9 × 10⁵. The polymer compound in the form of a thin film emitted light of blue color of 460 nm.

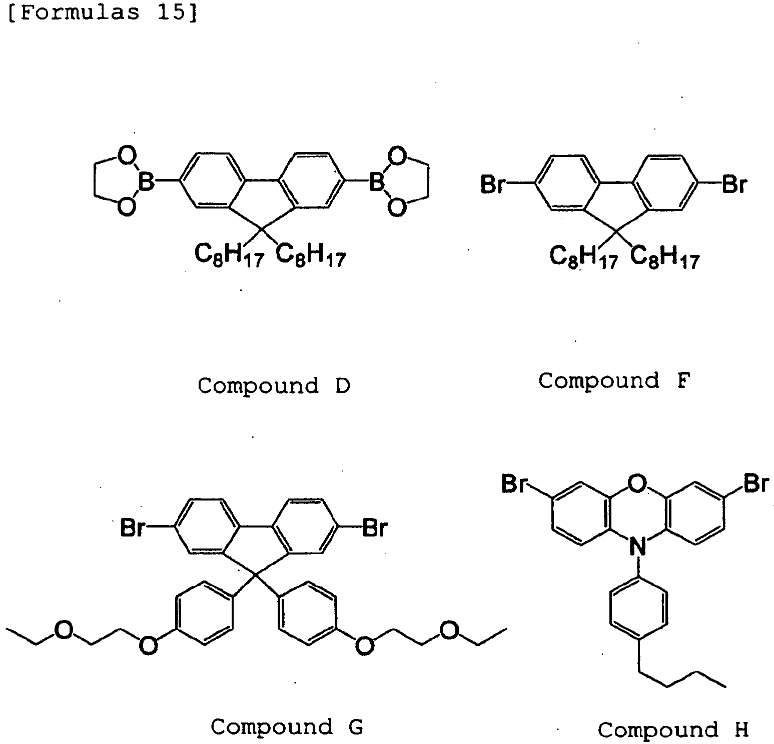

### <Formation of layer 1 (light-emitting layer)>

As shown in Table 1, 1% by weight of the polymer compounds 1 and 3 were added to toluene, and, furthermore, 25% by weight of dipentaerythritol hexaacrylate (KAYARAD DPHA (trade name) manufactured by Nippon Kayaku Co., Ltd.) based on the polymer compounds was added as a crosslinking agent. Thereafter, the mixture was filtered with Teflon (trademark) filter of 0.2 micron in diameter to prepare a coating solution. A film of the solution was formed by spin coating on a glass substrate having an ITO film of 150 nm thick formed by sputtering method, and the resulting film was baked under baking conditions of 300°C/20 min in a nitrogen atmosphere.

### <Formation of light-emitting layer 2>

As shown in Table 1, 0.5% by weight of the polymer compound 2 was added to toluene, and, furthermore, 160% by weight of 4,4'-bis(9-carbazoyl)-biphenyl (DCBP (trade name) manufactured by Dojindo Laboratories) based on the polymer compound was added to dissolve the polymer compound. Thereafter, the solution was filtered with Teflon (trademark) filter of 0.2 micron in diameter to prepare a coating solution. A film of the resulting coating solution of polymer light-emitting material in a thickness of about 70 nm was formed by spin coating on the light-emitting layer 1 to form a light-emitting layer 2. The resulting laminate was dried at 90°C for 1 hour under reduced pressure, and, then, thereon were vapor deposited lithium fluoride in a thickness of 4 nm as a negative electrode buffer layer, calcium in a thickness of 5 nm as a negative electrode, and then aluminum in a thickness of 100 nm to produce a polymer LED. Degree of vacuum in vapor deposition was 1-9 × 10⁻⁵ Torr. A voltage was applied stepwise to the resulting device having a light-emitting part of 2 mm × 2 mm (4 mm² in area) to measure the luminance of EL light emission from the polymer light-emitting material, from which a current efficiency value was obtained. The maximum value of current efficiency of the device, and the CIE chromaticity coordinates (x, y) of the EL light emission at that time are shown in Table 1. [Table 1]

**Table 1**

| | Example |
|---|---|
| Composition of polymer | Polymer compound |
| compound used in layer 1 | 1/3=90/10 |
| Composition of polymer | Polymer compound |
| compound used in layer 2 | 2=100 |
| Maximum efficiency (cd/A) | 1.44 |
| Chromaticity (x, y) | 0.43, 0.25 |

The device of the Example showed high efficiency whitelight emission of spectrum having two peaks at 450 nm and 610 nm.

### <Formation of layer 3 (hole injection layer)>

As shown in Table 2, 1% by weight of the polymer compound 4 was added to toluene, and, furthermore, 25% by weight of dipentaerythritol hexaacrylate (KAYARAD DPHA (trade name) manufactured by Nippon Kayaku Co., Ltd.) based on the polymer compound was added as a crosslinking agent. Thereafter, the mixture was filtered with Teflon (trademark) filter of 0.2 micron in diameter to prepare a coating solution. A film of the solution was formed by spin coating on a glass substrate having an ITO film of 150 nm thick formed by sputtering method, and the resulting film was baked under baking conditions of 300°C/20 min in a nitrogen atmosphere. The film thickness was 25 nm measured by a feeler type film thickness meter (DEKTAK manufactured by Veeco Co., Ltd.).

### <Formation of layer 4 (light-emitting layer)>

As shown in Table 2, 0.5% by weight of the polymer compound 3 was added to toluene, and, furthermore, 25% by weight of dipentaerythritol hexaacrylate (KAYARAD DPHA (trade name) manufactured by Nippon Kayaku Co., Ltd.) based on the polymer compound was added as a crosslinking agent. Thereafter, the mixture was filtered with Teflon (trademark) filter of 0.2 micron in diameter to prepare a coating solution. A film of the solution was formed by spin coating on the layer 3 (hole injection layer) formed on the ITO substrate, and the resulting film was baked under baking conditions of 300°C/20 min in a nitrogen atmosphere. The film thickness was 7 nm measured by a feeler type film thickness meter (DEKTAK manufactured by Veeco Co., Ltd.).

### <Formation of layer 5 (light-emitting layer)>

As shown in Table 2, the polymer compound 5 was dissolved in toluene at a concentration of 1% by weight. Thereafter, the solution was filtered with Teflon (trademark) filter of 0.2 micron in diameter to prepare a coating solution. A film of the resulting coating solution of polymer light-emitting material in a thickness of about 70 nm was formed by spin coating on the light-emitting layer 4 to form a light-emitting layer 5. The resulting laminate was dried at 90°C for 1 hour under reduced pressure, and, then, thereon were vapor deposited lithium fluoride in a thickness of 4 nm as a negative electrode buffer layer, and aluminum in a thickness of 100 nm as a negative electrode to produce a polymer LED. Degree of vacuum in vapor deposition was 1-9 × 10⁻⁵ Torr. A voltage was applied stepwise to the resulting device having a light-emitting part of 2 mm × 2 mm (4 mm² in area) to measure the luminance of EL light emission from the polymer light-emitter, from which a current efficiency value was obtained. The maximum value of current efficiency of the device, and the CIE chromaticity coordinates (x, y) of the EL light emission at that time are shown in Table 2.

[Table 2]

**Table 2**

| | Example 2 |
|---|---|
| Composition of polymer | Polymer compound |
| compound used in layer 3 | 4=100 |
| Composition of polymer | Polymer compound |
| compound used in layer 4 | 3=100 |
| Composition of polymer | Polymer compound |
| compound used in layer 5 | 5=100 |
| Maximum efficiency (cd/A) | 2.88 |
| Chromaticity (x,y) | 0.42, 0.28 |

The device of the Example showed high efficiency whitelight emission of spectrum having two peaks at 460 nm and 610 nm.

### Industrial Applicability

The present invention provides a white organic electroluminescent device excellent in device performances such as efficiency.

## Claims

1. A white organic electroluminescent device which comprises a laminate of at least two light-emitting layers emitting light of different colors, the light-emitting layers being located between electrodes comprising a positive electrode and a negative electrode, at least one of which electrodes is transparent or translucent, and wherein the light-emitting layers contain a polymer material as a charge-transporting material or a light-emitting material, at least one of the light-emitting layers being a crosslinked light-emitting layer, which light-emitting layers emit a white light as a whole.

2. A white organic electroluminescent device according to claim 1, wherein at least one of the light-emitting layers is a non-crosslinked light-emitting layer, and wherein at least one of the crosslinked light-emitting layers and at least one of the non-crosslinked light-emitting layers are in contact with each other.

3. A device according to claim 1 or 2 which is obtained by a method including steps of forming a crosslinkable light-emitting layer by coating, crosslinking the light-emitting layer, and then laminating other light-emitting layer on the crosslinked light-emitting layer.

4. A device according to claim 3, wherein the crosslinking is carried out with a crosslinking agent and the crosslinking agent contains no aromatic ring.

5. A device according to claim 4, wherein the crosslinking agent has a group selected from a group consisting of vinyl group, acetylene group, butenyl group, acryl group, acrylate group, acrylamide group, methacryl group, methacrylate group, methacrylamide group, vinyl ether group, vinylamino group, silanol group, cyclopropyl group, cyclobutyl group, epoxy group, oxetane group, diketene group, episulfide group, lactone group and lactam group.

6. A device according to any one of claims 4 and 5, wherein the crosslinking agent is a (meth)acrylate, preferably a (meth)acrylate of an aliphatic alcohol.

7. A device according to claim 6, wherein the crosslinking agent is a bi- or higher-functional (meth)acrylate, preferably dipentaerythritol penta- or hexa-acrylate.

8. A device according to any one of claims 1-7, wherein the polymer material is a conjugated polymer compound.

9. A device according to any one of claims 1-8, wherein the polymer material has a repeating unit derived from an aromatic amine.

10. A device according to any one of claims 1-9, wherein the colors of lights emitted from at least two light-emitting layers are red and blue.

11. A planar light source using the device of any one of claims 1-10.

12. A segment display apparatus using the device of any one.of claims 1-10.

13. A dot matrix display apparatus using the device of any one of claims 1-10 as a back light.

14. A liquid crystal display apparatus using the device of any one of claims 1-10 as a back light.

## Patentansprüche

1. Eine weiße organische Elektrolumineszenzvorrichtung, die ein Laminat aus mindestens zwei Licht emittierende Schichten, welche Licht in verschiedenen Farben emittieren, umfasst, wobei die Licht emittierenden Schichten zwischen Elektroden, die eine positive Elektrode und eine negative Elektrode umfassen, angeordnet sind, mindestens eine dieser Elektroden transparent oder transluzent ist und wobei die Licht emittierenden Schichten ein Polymermaterial als ein ladungstransportierendes Material oder ein Licht emittierendes Material enthalten, mindestens eine der Licht emittierenden Schichten eine vernetzte Licht emittierende Schicht ist, wobei die Licht emittierenden Schichten als Ganzes ein weißes Licht emittieren.

2. Eine weiße organische Elektrolumineszenzvorrichtung gemäß Anspruch 1, wobei mindestens eine der Licht emittierenden Schichten eine nicht vernetzte Licht emittierende Schicht ist und wobei mindestens eine der vernetzten Licht emittierenden Schichten und mindestens eine der nicht vernetzten Licht emittierenden Schichten in Kontakt miteinander stehen.

3. Eine Vorrichtung gemäß Anspruch 1 oder 2, welche durch ein Verfahren erhalten wird, welches die Schritte des Bildens einer vernetzbaren Licht emittierenden Schicht durch Beschichten, Vernetzen der Licht emittierenden Schicht und dann Laminieren einer anderen Licht emittierenden Schicht auf die vernetzte Licht emittierende Schicht einschließt.

4. Eine Vorrichtung gemäß Anspruch 3, wobei das Vernetzen mit einem Vernetzungsmittel durchgeführt wird und das Vernetzungsmittel keinen aromatischen Ring enthält.

5. Eine Vorrichtung gemäß Anspruch 4, wobei das Vernetzungsmittel einen Rest aufweist, ausgewählt aus einer Gruppe bestehend aus einem Vinylrest, Acetylenrest, Butenylrest, Acrylrest, Acrylatrest, Acrylamidrest, Methacrylrest, Methacrylatrest, Methacrylamidrest, Vinyletherrest, Vinylaminorest, Silanolrest, Cyclopropylrest, Cyclobutylrest, Epoxyrest, Oxetanrest, Diketenrest, Episulfidrest, Lactonrest und Lactamrest.

6. Eine Vorrichtung gemäß einem der Ansprüche 4 und 5, wobei das Vernetzungsmittel ein (Meth)acrylat, vorzugsweise ein (Meth)acrylat eines aliphatischen Alkohols, ist.

7. Eine Vorrichtung gemäß Anspruch 6, wobei das Vernetzungsmittel ein bi- oder höherfunktionelles (Meth)acrylat, vorzugsweise Dipentaerythritpenta- oder -hexaacrylat, ist.

8. Eine Vorrichtung gemäß einem der Ansprüche 1 bis 7, wobei das Polymermaterial eine konjungierte Polymerverbindung ist.

9. Eine Vorrichtung gemäß einem der Ansprüche 1 bis 8, wobei das Polymermaterial eine Wiederholungseinheit, die sich von einem aromatischen Amin ableitet, aufweist.

10. Eine Vorrichtung gemäß einem der Ansprüche 1 bis 9, wobei die Farben der Lichter, die von mindestens zwei Licht emittierenden Schichten emittiert werden, Rot und Blau sind.

11. Eine planare Lichtquelle, welche die Vorrichtung gemäß einem der Ansprüche 1 bis 10 verwendet.

12. Ein Segmentanzeigevorrichtung, welche die Vorrichtung gemäß einem der Ansprüche 1 bis 10 verwendet.

13. Ein Punktmatrixanzeigevorrichtung, welche die Vorrichtung gemäß einem der Ansprüche 1 bis 10 als Hintergrundbeleuchtung verwendet.

14. Eine Flüssigkristallanzeigevorrichtung, welche die Vorrichtung gemäß einem der Ansprüche 1 bis 10 als Hintergrundbeleuchtung verwendet.

## Revendications

1. Dispositif électroluminescent organique blanc qui comprend un stratifié d'au moins deux couches émettant de la lumière émettant de la lumière de couleurs différentes, les couches émettant de la lumière étant situées entre des électrodes comprenant une électrode positive et une électrode négative, électrodes dont l'une au moins est transparente ou translucide, et où les couches émettant de la lumière contiennent une matière polymère comme matière transportant des charges ou matière émettant de la lumière, au moins l'une des couches émettant de la lumière étant une couche émettant de la lumière réticulée, lesquelles couches émettant de la lumière émettent une lumière blanche globalement.

2. Dispositif électroluminescent organique blanc selon la revendication 1, où au moins l'une des couches émettant de la lumière est une couche émettant de la lumière non réticulée, et où au moins l'une des couches émettant de la lumière réticulées et au moins l'une des couches émettant de la lumière non réticulées sont en contact entre elles.

3. Dispositif selon la revendication 1 ou 2 qui est obtenu par un procédé incluant des étapes de formation d'une couche émettant de la lumière réticulable par application en revêtement, réticulation de la couche émettant de la lumière puis stratification d'autres couches émettant de la lumière sur la couche émettant de la lumière réticulée.

4. Dispositif selon la revendication 3, où la réticulation est conduite avec un agent réticulant et l'agent réticulant ne contient pas de cycle aromatique.

5. Dispositif selon la revendication 4, où l'agent réticulant a un groupe choisi dans un groupe consistant en un groupe vinyle, un groupe acétylène, un groupe butényle, un groupe acrylique, un groupe acrylate, un groupe acrylamide, un groupe méthacrylique, un groupe méthacrylate, un groupe méthacrylamide, un groupe vinyléther, un groupe vinylamino, un groupe silanol, un groupe cyclopropyle, un groupe cyclobutyle, un groupe époxy, un groupe oxétane, un groupe dicétène, un groupe épisulfure, un groupe lactone et un groupe lactame.

6. Dispositif selon l'une quelconque des revendications 4 et 5, où l'agent réticulant est un (méth)acrylate, de préférence un (méth)-acrylate d'un alcool aliphatique.

7. Dispositif selon la revendication 6, où l'agent réticulant est un (méth)acrylate bifonctionnel ou de fonctionnalité supérieure, de préférence le penta- ou hexa-acrylate de dipentaérythritol.

8. Dispositif selon l'une quelconque des revendications 1-7, où la matière polymère est un composé polymère conjugué.

9. Dispositif selon l'une quelconque des revendications 1-8, où la matière polymère a une unité répétée dérivée d'une amine aromatique.

10. Dispositif selon l'une quelconque des revendications 1-9, où les couleurs de lumières émises par au moins deux couches émettant de la lumière sont le rouge et le bleu.

11. Source lumineuse plane utilisant le dispositif selon l'une quelconque des revendications 1-10.

12. Appareil d'affichage à segments utilisant le dispositif selon l'une quelconque des revendications 1-10.

13. Appareil d'affichage à matrice de points utilisant le dispositif selon l'une quelconque des revendications 1-10 comme éclairage de fond.

14. Appareil d'affichage à cristaux liquides utilisant le dispositif selon l'une quelconque des revendications 1-10 comme éclairage de fond.
